# EUROPEAN PATENT APPLICATION

(11) **EP 4 718 977 A1**
(43) Date of publication of application: **01.04.2026**
(21) Application number: 25191235.8
(22) Date of filing: 23.07.2025
(51) Int. Cl.: H10D 30/01, H10D 30/00, H10D 62/17, B82Y 10/00, H10D 30/69

(54) **FABRICATING HIGH QUALITY, HIGH STRESS CHANNEL REGIONS IN GATE-ALL-AROUND FIELD EFFECT TRANSISTORS (GAA FETS)**

(30) Priority: 27.09.2024 US 202418899234
(71) Applicant: INTEL Corporation, Santa Clara, CA 95054 (US)
(72) Inventor: MANGU, Vijay Saradhi, Fremont, 94536 (US); GHOSE, Susmita, Hillsboro (US); GHANI, Tahir, Portland, 97229 (US); GLASS, Glenn, Portland, 97229 (US); PAIK, Marvin, Portland, 97229 (US); JORGENSEN, Kelsey, Beaverton, 97007 (US); MURTHY, Anand, Portland, 97229 (US); BUDREVICH, Aaron, Portland (US); RAJASEKHARA, Shreyas, Portland, 97229 (US); ONI, Adedapo, North Plains (US); LIN, Jianqiang, Portland, 97229 (US)
(74) Representative: Viering, Jentschura & Partner mbB Patent- und Rechtsanwälte

(57) **Abstract**

In embodiments of the present disclosure, enhanced nanoribbons of GAA FETs are formed using a high-temperature diffusion process before the source/drain regions are formed. The diffusion process includes forming an additive material layer (212), for example comprising germanium, around crystalline nanoribbons (210), for example comprising silicon, (Fig. 2D), forming a capping layer (214) around the additive material layer (212) (Fig. 2D), diffusing the additive material into the crystalline nanoribbons via heating, (Fig. 2E), and removing the capping layer (214) (Fig. 2F).

## Description

### BACKGROUND

While strain on a transistor channel can increase the mobility of charge carriers through the channel, the delivery of strain on channels is difficult or diminished in some transistor structures, e.g., in certain types of transistors. For example, in gate-all-around (GAA) field-effect transistors (FETs) (e.g., with nanowire channels), uniaxial stress is not exerted (or at least not to the same extent, relative to FinFETs) by source and drain epitaxial bodies grown from the ends of channels. With multiple nanowires between epi regions in GAA FETs, source/drain regions may be merged. This can lead to polycrystalline bodies with multiple faults or dislocations that preclude the provision of satisfactory strain by source/drain regions, which may limit carrier mobilities in some transistor structures.

Some techniques for fabricating high stress channel regions may utilize a high temperature diffusion process for converting silicon channel regions to silicon germanium (SiGe). However, these high-temperature processes may be detrimental to the doped source/drain regions of the transistors, leading to dopant out-diffusion into the channel region.

### BRIEF DESCRIPTION OF THE DRAWINGS

FIGS. 1A-1D are perspective views of example planar, FinFET, gate-all-around (GAA), and stacked gate-all-around transistors.
FIGS. 2A-2F illustrate an example process 200 of forming enhanced nanoribbons in accordance with some embodiments.
FIGS. 3A-3B illustrates example cross-sectional views of the enhanced nanoribbons formed by the process of FIGS. 2A-2F.
FIGS. 4A-4I illustrate an example process 400 of forming GAA FETs in accordance with some embodiments.
FIGS. 5A-5K illustrate another example process 500 of forming GAA FETs in accordance with some embodiments.
FIG. 6 is a top view of a wafer and dies that may include embodiments disclosed herein.
FIG. 7 is a cross-sectional side view of an integrated circuit device that may include embodiments herein.
FIG. 8 is a cross-sectional side view of an integrated circuit device assembly that may include embodiments disclosed herein.
FIG. 9 is a block diagram of an example electrical device that may include embodiments disclosed herein.

### DETAILED DESCRIPTION

Embodiments herein relate to techniques for fabricating for gate-all-around (GAA) field effect transistors (FETs), e.g., p-type GAA FETs, with high quality, high stress channel regions. In particular, high D*t nanoribbons may be formed for GAA FETs using a high-temperature, vacancy-mediated diffusion process before source/drain epitaxial (epi) regions are formed. For instance, a layer of material comprising additive elements may be deposited on and around nanoribbon channels, and atoms of the additive element(s) may be introduced into, and thoroughly interspersed in, the crystal lattice of the nanoribbon channel by vacancy-assisted diffusion, e.g., to improve one or more characteristics of the channel. Oxygen (and/or nitrogen, etc.) vacancies may be introduced by a capping layer that encapsulates the nanoribbon channel and the layer comprising the additive element(s), and retains the vacancy element(s) during the diffusion process. Such diffusion can ensure a homogenous composition in the nanoribbon channel, and can preclude adverse effects of an interface between unmatched lattices, such as non-uniform strain, reduced carrier mobilities, and increased leakage current.

In some fabrication methods, though, this diffusion process can cause dopant out-diffusion from the source/drain epi regions into the nanoribbon channel regions. However, performing the nanoribbon diffusion process before formation of the epi regions as disclosed herein can avoid impacting the doping in source/drain epi regions, which can yield pristine channel/epi junctions having dopants only located near EUC (etch undercut) areas in certain instances.

In embodiments herein, for example, GAA FET channels may be initially fabricated using conventional materials and/or existing processes, and the channel lattice may then be modified by the addition of a new element. For example, germanium atoms may be added to nanoribbons consisting of purely or predominantly silicon (without germanium) via the diffusion process described above and further herein. The resulting structure may have superior channel qualities due to the general electrical qualities of silicon germanium, as well as the compressive strain caused by the larger lattice constant relative to the preexisting silicon nanoribbon. The alteration of the channel lattice may be especially advantageous given the difficulty in otherwise effecting strain in GAA FET channels between merged source and drain bodies. To avoid out-diffusion of dopants from the source/drain regions to the channel regions, the high temperature diffusion process may be performed before formation of the epi source/drain regions, allowing for uniform, high stress channels that are free from any dopants.

While fabrication of transistors with SiGe channels (e.g., p-type transistors or pFETs) is disclosed herein, advantageously, the methods provided herein can be implemented in the fabrication of devices comprising purely or predominately Si channels (e.g., n-type transistors or nFETs). This is because the methods described herein enable the use of one material (e.g., silicon) for the fabrication of the different types of GAA FETs, which clearly has benefits in the fabrication of CMOS (complementary MOS (metal-oxide-semiconductor)) integrated circuit (IC) devices. The channels of differing materials, with and without the added element(s), may be positioned as channels would be in the established process, for example, parallel and at identical heights in stacks with identical pitches.

Besides the compressive effect provided by the techniques herein, the use of silicon germanium channels otherwise improves pFET performance (e.g., by increasing mobility and reducing threshold voltage V_{T}) and reliability (e.g., having reduced negative-bias temperature instability (NBTI)). Although the example of adding germanium into a lattice of silicon is discussed herein, other materials may be employed (e.g., as an added, diffused element or as an initial lattice) to introduce or alter other characteristics and/or to exert another type or magnitude of strain. For example, nanoribbons may be enhanced to include III-V materials, II-VI materials, or other semiconducting materials.

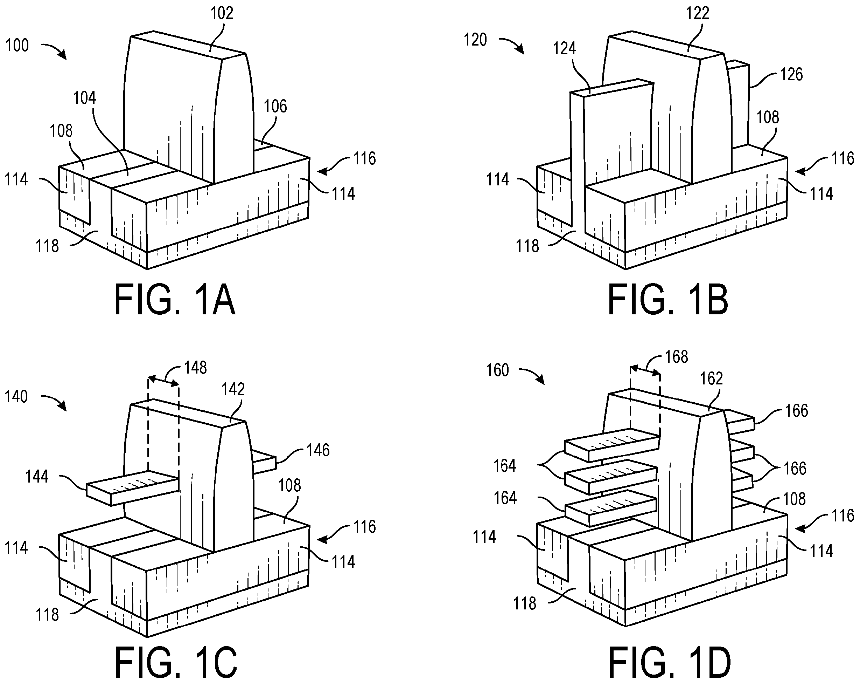

FIGS. 1A-1D are simplified perspective views of example planar, FinFET, gate-all-around, and stacked gate-all-around transistors. Any of the example transistors shown (including their variants) can include a relaxor type ferroelectric gate dielectric layer in accordance with embodiments of the present disclosure. The transistors illustrated in FIGS. 1A-1D are formed on a substrate 116 having a surface 108. Isolation regions 114 separate the source and drain regions of the transistors from other transistors and from a bulk region 118 of the substrate 116.

FIG. 1A is a perspective view of an example planar transistor 100 comprising a gate 102 that controls current flow between a source region 104 and a drain region 106. The transistor 100 is planar in that the source region 104 and the drain region 106 are planar with respect to the substrate surface 108.

FIG. 1B is a perspective view of an example FinFET transistor 120 comprising a gate region 122 that controls current flow between a source region 124 and a drain region 126 (through a channel region inside the gate region 122). The transistor 120 is non-planar in that the source region 124 and the drain region 126 comprise "fins" that extend upwards from the substrate surface. As the gate region 122 is formed around three sides of the semiconductor fin that extends from the source region 124 to the drain region 126, the transistor 120 can be considered a tri-gate transistor. FIG. 1B illustrates one S/D fin extending through the gate region 122, but multiple S/D fins can extend through the gate of a FinFET transistor.

FIG. 1C is a perspective view of a gate-all-around (GAA) transistor 140 comprising a gate region 142 that controls current flow between a source region 144 and a drain region 146 (through a channel region inside the gate region 142). The transistor 140 is non-planar in that the source region 144 and the drain region 146 are elevated from the substrate surface.

FIG. 1D is a perspective view of a GAA transistor 160 comprising a gate region 162 that controls current flow between multiple elevated source regions 164 and multiple elevated drain regions 166 (through respective channel regions inside the gate region 162). The transistor 160 is a stacked GAA transistor as the gate controls the flow of current between multiple elevated S/D regions stacked on top of each other.

The transistors 140 and 160 are each considered gate-all-around transistors as the gates encompass all sides of the semiconductor portions that extends from the source regions to the drain regions, forming the transistor channels. The transistors 140 and 160 can alternatively be referred to as nanowire, nanosheet, or nanoribbon transistors depending on the width (e.g., widths 148 and 168 of transistors 140 and 160, respectively) or shape of the semiconductor portions extending through the gate. Although the transistor 160 includes three semiconductor portions (nanowires, nanosheets, or nanoribbons) extending through the gate region 162, other embodiments may include two or more than three semiconductor portions.

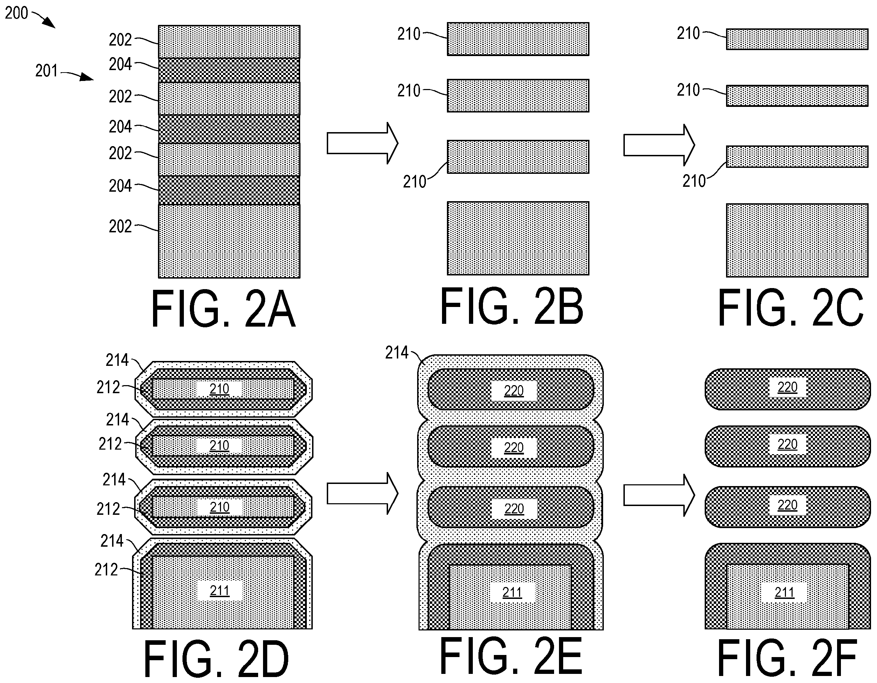

FIGS. 2A-2F illustrate an example process 200 of forming enhanced nanoribbons in accordance with some embodiments. In particular, FIGS. 2A-2F illustrate cross-sectional profile views of nanoribbons having an added element diffused into the crystal lattices, at various stages of manufacture, in accordance with some embodiments. Thus, FIGS. 2A-2F show possible examples of intermediate structures during the process described below. The example process 200 may include fewer, additional, or other operations than those shown. Moreover, the operations of the process 200 can be performed in another order than shown. Furthermore, some of the operations shown or described as being separate may be performed simultaneously, while some of the operations shown or described as being performed at the same time may be performed at different times. Although a certain number of nanoribbons are shown, any number of nanoribbons or other types of channels can be formed using the process 200.

The process 200 begins with a stack 201 of material layers as shown in FIG. 2A. The stack 201 may be formed by depositing alternating material layers in a stack, e.g., alternating layers of a crystalline (e.g., semiconducting) material (in layers 202) and of a sacrificial material (in layers 204). In some embodiments, the materials share one or more constituent elements. For example, in some embodiments, the sacrificial material is silicon germanium (SiGe) and the semiconducting material is pure (or predominantly) silicon (e.g., without germanium present). Any suitable materials may be employed, such as materials that may be semiconductors (e.g., enhanced) with the addition of one or more elements diffused into the crystalline lattice. Although the examples of silicon and germanium may be provided, the nanoribbons may be enhanced to include III-V materials, II-VI materials, and other semiconducting materials.

As shown in FIG. 2B, nanoribbons 210 of the semiconducting material in layers 202 of the stack 201 may be formed. The nanoribbons 210 may be formed using known fabrication techniques. Then, as shown in FIG. 2C, the nanoribbons 210 may be thinned (i.e., have their thickness reduced) to allow for the resulting thickness of the nanoribbons (after the additional processing operations are performed) to be similar to the thickness shown in FIG. 2B. This reduction in thickness may be done because the enhancement of the nanoribbons via the remaining operations will increase the overall thickness/size of the nanoribbons. The nanoribbons may be thinned by any suitable means, e.g., by a selective plasma etch. In many embodiments, the nanoribbons are thinned by isotropically removing material from exposed surfaces of the nanoribbons. In some such embodiments, the nanoribbons are predominantly silicon, and (e.g., an outer layer of) silicon is removed isotropically from all exposed nanoribbon surfaces. The nanoribbons may be thinned to between 1-5 nm thickness, e.g., approximately 2 nm or 3nm thick. Then, as shown in FIG. 2D, an additive element layer 212 is deposited conformally on the nanoribbons 210, and a capping layer 214 is deposited conformally on the additive element layer 212. The same layers may be deposited on the sub-fin 211 as well, as shown.

The additive element layer 212 may include an element that is to be diffused into the nanoribbons 210. For example, the additive element layer 212 may include germanium (e.g., the layer 212 may be SiGe) that is to be diffused into the lattice of the nanoribbons 210, creating an "enhanced nanoribbon". The final concentration of the added element in an enhanced nanoribbon is influenced by a number of variables, such as the initial concentration of the added element in the initial nanoribbon (e.g., zero), the size (e.g., volume) of the initial nanoribbon, the initial concentration of the added element in the deposited material layer, and the size (e.g., thickness) of the deposited material layer. The final concentration of the added element can be increased by depositing a thicker material layer or a material layer with a higher concentration of the added element, but the final concentration of the added element in the enhanced nanoribbon is limited by the size of the initial nanoribbon. The smaller (e.g., thinner) the initial nanoribbon is, the more the final concentration of the added element in the enhanced nanoribbon can be influenced with the deposited material layer.

The additive element layer 212 may be deposited epitaxially in certain embodiments, e.g., by an atomic layer deposition (ALD) process, which allows for great control of the thickness of the deposited material layer, and so for great control of the final concentration of the added element in the enhanced nanoribbon. Epitaxial deposition by ALD may ensure a high-quality lattice is deposited on the nanoribbon, which may improve subsequent diffusion of the additive element into the nanoribbon. Epitaxial deposition by ALD may also enable selective deposition of the additive element onto the nanoribbon. The additive material layer 212 may be deposited to a thickness of at least 1 nm, e.g., 1.5 nm or more, which may correspond to a sufficient concentration of the added element in the final nanoribbon.

For example, in some embodiments, the layer 212 may be a layer of silicon germanium (SiGe) is epitaxially and conformally deposited over the nanoribbons 210, which are predominantly silicon. The SiGe layer may be deposited to an atomic composition including at least 20% germanium, which can allow for the resulting enhanced nanoribbon has a germanium concentration of at least 20% (e.g., for increased strain, hole mobility, and/or improved reliability). In some embodiments, for instance, the additive material layer 212 may have a germanium concentration of 65% (or less) deposited over silicon nanoribbons 210, which may provide more germanium (e.g., in less space) while maintaining margin below a critical thickness. Thus, the resulting enhanced nanoribbon 220 may show uniform and homogenous SiGe, with a germanium concentration of between 25%-60%, in certain embodiments.

The capping layer 214 may be deposited conformally on the additive material layer 212 after growth of the layer 212. The capping layer 214 may function to encapsulate the layers 210, 212 during subsequent processing, as described below, and may be a sacrificial layer to e removed after the subsequent processing. The capping layer 214 may include any suitable capping material(s) and may encase the nanoribbons 210 and additive material layer 212 by any suitable means. In certain embodiments, the capping layer 214 is a dielectric layer. In some embodiments, the capping layer 214 is (or includes) an oxide (e.g., silicon oxide) or a nitride (e.g., silicon nitride), which may provide lattice vacancies for assisting (e.g., enhancing) diffusion. The encapsulation of the nanoribbons 210 and additive material layer 212 by the capping layer 214 may be necessary to contain lattice materials during a high-temperature diffusion process, e.g., lattice materials that might otherwise precipitate and agglomerate at an external nanoribbon surface. In some embodiments, the capping layer 214 is deposited to a thickness of 2 nm or less, which may be a sufficient thickness to ensure retention of the nanoribbon materials and the additive material layer (e.g., even during a longer or higher-temperature diffusion), but to also provide sufficient clearance for material deposition and removal. In many embodiments, the nanoribbons and additive material layer are encased in the capping layer 214 by conformally depositing the capping layer 214 around each of the nanoribbons. In some embodiments, the capping layer 214 may be epitaxially deposited (e.g., by ALD) as a high-quality, low-defect crystalline layer.

In some embodiments, the capping layer 214 is deposited over a passivation layer (e.g., of a native oxide) is formed on the nanoribbons/additive material layer, which may also provide diffusion-assisting vacancies. The capping layer 214 may also enhance diffusion by providing compressive (or tensile) stress on the additive material layer and nanoribbon. In some embodiments, the capping layer 214 is silicon nitride (e.g., an epitaxially and conformally deposited, high-quality, low-defect crystalline layer of silicon and nitrogen). A capping layer 214 of silicon nitride may provide both strain (e.g., from up to 3 GPa of compressive or tensile stress) and vacancies of oxygen and/or nitrogen for subsequent diffusion. Strain- and vacancy-assisted diffusion of the nanoribbon materials and the deposited material layer (e.g., while retained in a layer of silicon nitride) may enable a reduced diffusion temperature or duration, which may provide margin to thermal-budget requirements.

After the layers 212, 214 are deposited, a high temperature diffusion process may be performed to diffuse the additive element into the nanoribbons 210. The additive element may be diffused into the nanoribbons by any suitable means, for example, a rapid thermal anneal (RTA), such as a plasma anneal at a low partial pressure of oxygen. The diffusion may be performed to a satisfactory mixing (e.g., a thorough evening out of the concentrations and elimination of any concentration gradient), for example, by diffusing for a sufficiently long duration, at a sufficiently high temperature, etc. For example, germanium may diffuse from a conformally deposited layer (212) of silicon germanium into a silicon nanoribbon (210), and silicon may diffuse from the nanoribbon outward until the silicon and germanium are thoroughly intermixed. The resulting nanoribbons may be a thickened, enhanced nanoribbon 220 with no discernible border between the thinned nanoribbon 210 and the deposited additive element layer 212, as shown in FIG. 2E. As described, strain and vacancies provided by the retaining layer may reduce a required diffusion temperature (e.g., to a few hundred degrees) and/or duration (e.g., to a few minutes or less than a minute) and provide margin to thermal-budget requirements. After the diffusion process, the capping layer 214 may be degraded (e.g., less pure and with a defective lattice), e.g., through out-diffusion of the additive element into the layer 214. In certain embodiments, for example, a capping layer 214 that initially included a high-quality silicon nitride may have an irregular lattice of silicon, nitrogen, and germanium.

Finally, as shown in FIG. 2F, the capping layer 214 is removed, leaving the enhanced nanoribbons 220 in place as shown. The removal of the layer 214 provides space for a gate electrode (e.g., a higher-K gate dielectric and work-function metals) between the nanoribbons. The capping layer 214 may be removed by any suitable means, e.g., a selective, dry etch. In some embodiments, the enhanced nanoribbons may be trimmed to a desired thickness. However, in other embodiments, the enhanced nanoribbons do not require a further trimming operation following diffusion and capping layer removal.

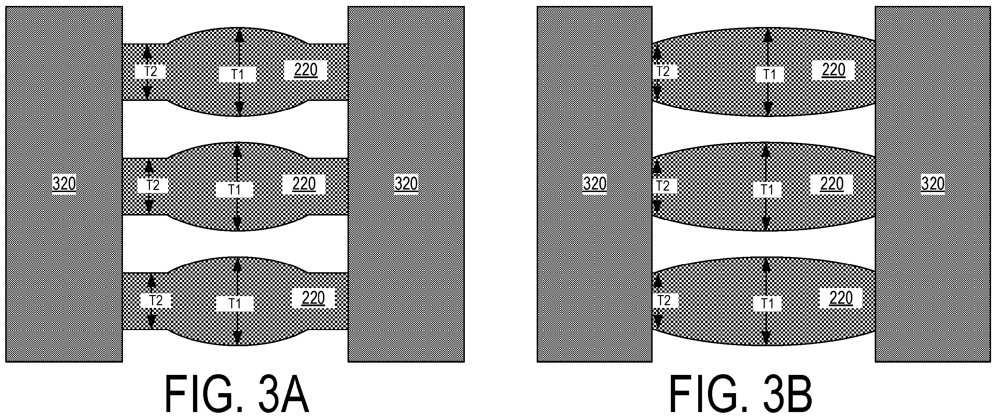

FIGS. 3A-3B illustrates example cross-sectional views of the enhanced nanoribbons formed by the process 200 of FIGS. 2A-2F. As shown in FIGS. 3A-3B, each of the enhanced nanoribbons 220 may have a bulge (e.g., thickness T1 at the midpoint of the channel being greater than thickness T2 adjacent the source/drain regions 320 on either side of the channel) caused by an enlarged lattice constant of the nanoribbon 220 (e.g., with an additional element relative to nanoribbons 210). In some instances, the enhanced nanoribbons 220 may have a minimum thickness at one end of the channel (adjacent the source/drain regions 320), and the thickness of the enhanced nanoribbon 220 may monotonically increase from the minimum thickness to the maximum thickness at the midpoint. The bulge of the nanoribbons may have another form than those shown.

Bulges in the nanoribbons 220 may be evidence of the additive element (e.g., germanium) having been added to the now-expanded lattice between ends of nanoribbons pinned to a smaller lattice constant (e.g., before expansion) at the source/drain regions 320. The additional element, even if deposited as a cladding on and around the nanoribbons, may be evenly spread (e.g., homogenously mixed by a thorough diffusion) throughout the nanoribbons, and the smoothness of the bulge may be due to surface tension acting to reduce surface area of the bulge and the enlarged nanoribbon. For example, the nanoribbons 220 may have a homogenous composition along a length of nanoribbons 220 (e.g., an axis or centerline) between the source/drain regions 320 on either side of the nanoribbons 220. Further, the nanoribbons 220 may have a homogenous composition along the thickness (e.g., T1) of the nanoribbons. In certain embodiments, a "homogenous composition" may refer to a concentration of the additive element (e.g., germanium) that is within approximately 5% of a nominal value (e.g., one between 20-70%) at different points in the volume of the nanoribbon.

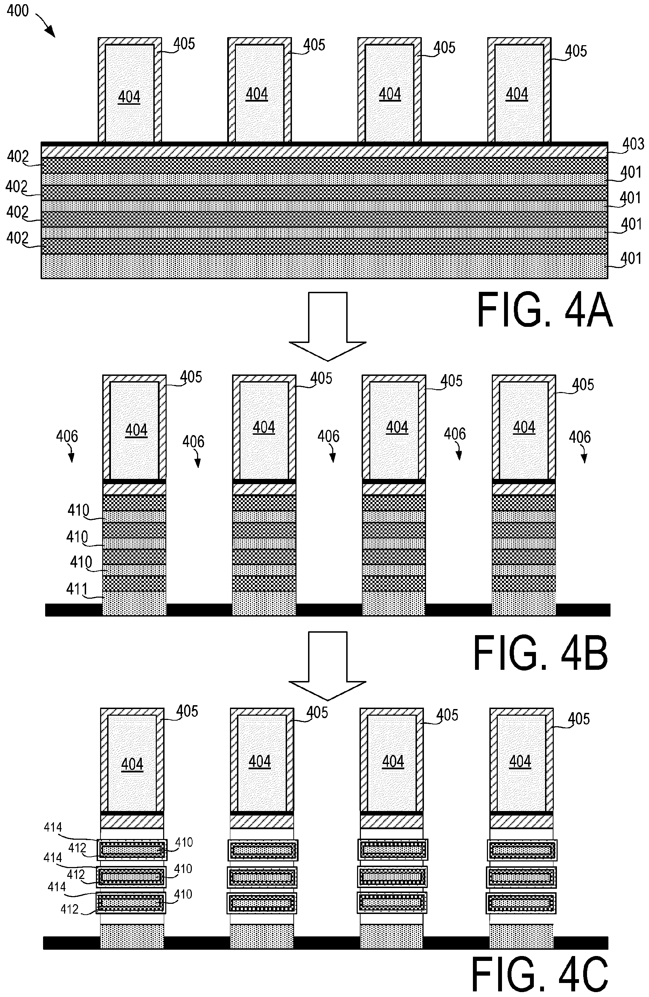

FIGS. 4A-4I illustrate an example process 400 of forming GAA FETs in accordance with some embodiments. The example process 400 may include fewer, additional, or other operations than those shown. Moreover, the operations of the process 400 can be performed in another order than shown. Furthermore, some of the operations shown or described as being separate may be performed simultaneously, while some of the operations shown or described as being performed at the same time may be performed at different times. Although a certain number of nanoribbons are shown in the transistors, any number of nanoribbons or other types of transistor channels can be formed using the process 400.

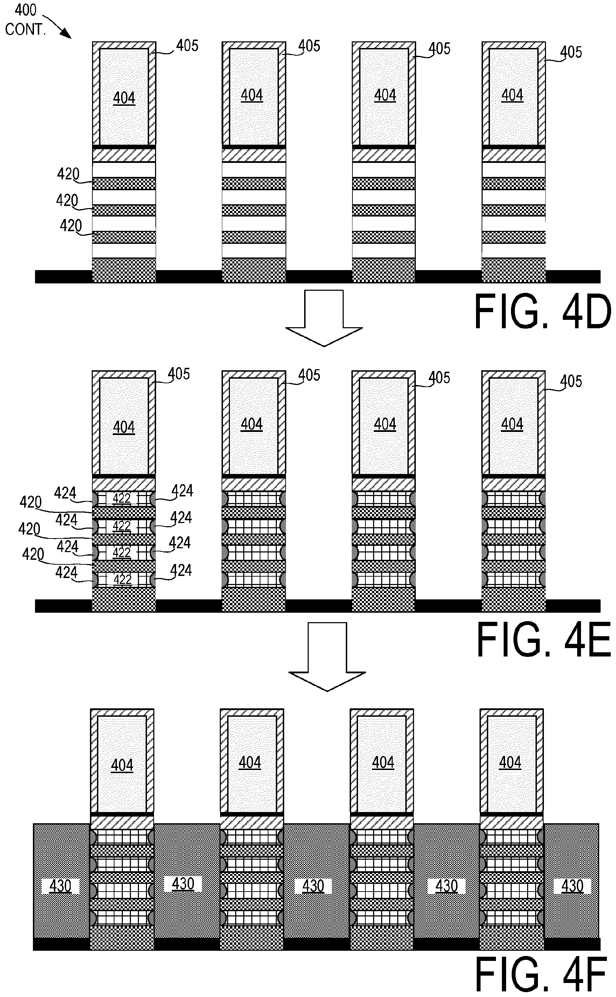

The process 400 begins as shown in FIG. 4A, with the formation of dummy gate regions 404 on a stack of materials, which includes layers 401, 402, 403. The layers 401 may include crystalline (e.g., semiconductor) materials and the layers 402 may include sacrificial materials. In some embodiments, the sacrificial material layers 402 may include silicon germanium (SiGe) and the crystalline material layers 401 may include pure (or predominantly) silicon (e.g., without germanium present). The layer 403 may include a dielectric. In addition, a dielectric layer 405 is formed on each of the dummy gate regions 404 as shown. The stack is then selectively etched in regions 406 as shown in FIG. 4B to form stacks of nanoribbons 410 (from the remaining portions of the layers 401) over respective sub-fins 411. The remaining portions of the layers 402 are then removed as shown in FIG. 4C, e.g., via known nanoribbon release processes, leaving released nanoribbons.

One or more aspects of the process described above with respect to FIGS. 2A-2F can then be performed on the released nanoribbons. For instance, as shown in FIG. 4C, a layer 412 of additive material is formed over each of the released nanoribbons 410 and then a layer 414 of capping material is formed over the layers 412. The layers 412 and 414 may be formed in the same manner as layers 212 and 214, respectively. Similarly, the layers 412, 414 may include the same or similar materials as layers 212, 214. The additive material in the layers 412 can then be diffused into the nanoribbons, yielding enhanced nanoribbons 420 as described above. The capping layer 414 can then be removed. The resulting structure is shown in FIG. 4D. In certain embodiments, the enhanced nanoribbons 420 may include uniform and homogenous silicon germanium, with a germanium concentration between approximately 20% and 70%.

Dielectric layers 422 can then be formed between the enhanced nanoribbons 420 as shown in FIG. 4E, and spacer dimples 424 can be formed in the sides of the dielectric layers 422 as shown. The spacer dimples 424 may include any suitable dielectric material, which may be the same or different dielectric from the layers 422.

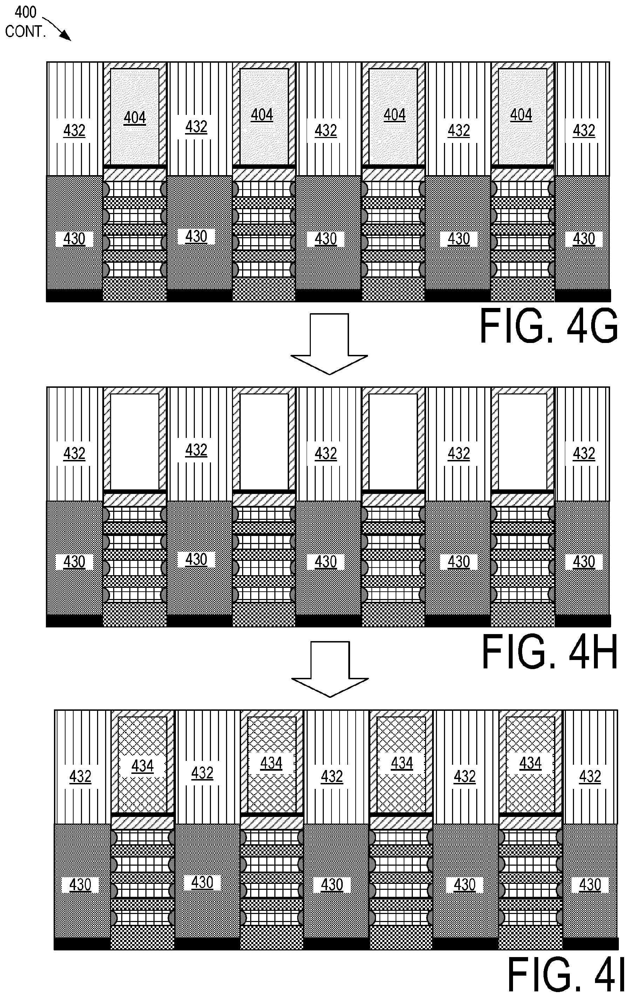

Next, source/drain regions 430 can be epitaxially formed on sides of the stacks of enhanced nanoribbons 420 as shown in FIG. 4F (e.g., epitaxially grown from the channel nanoribbons 420), and gate spacer dielectric 432 can be formed on each of the source/drain regions as shown in FIG. 4G. The dummy gate regions 404 can then be removed as shown in FIG. 4H and metal (or other conductive material) gate regions 434 can be formed in place of the dummy gate regions 404 as shown in FIG. 4I. Although FIGS. 4A-4I illustrate the source/drain regions 430 being formed before the gate regions 434, in other embodiments, the gate regions 434 may be formed before the source/drain regions 430. The source/drain regions 430 may be doped with one or more dopants, e.g., p-type dopants such as boron, aluminum, or gallium.

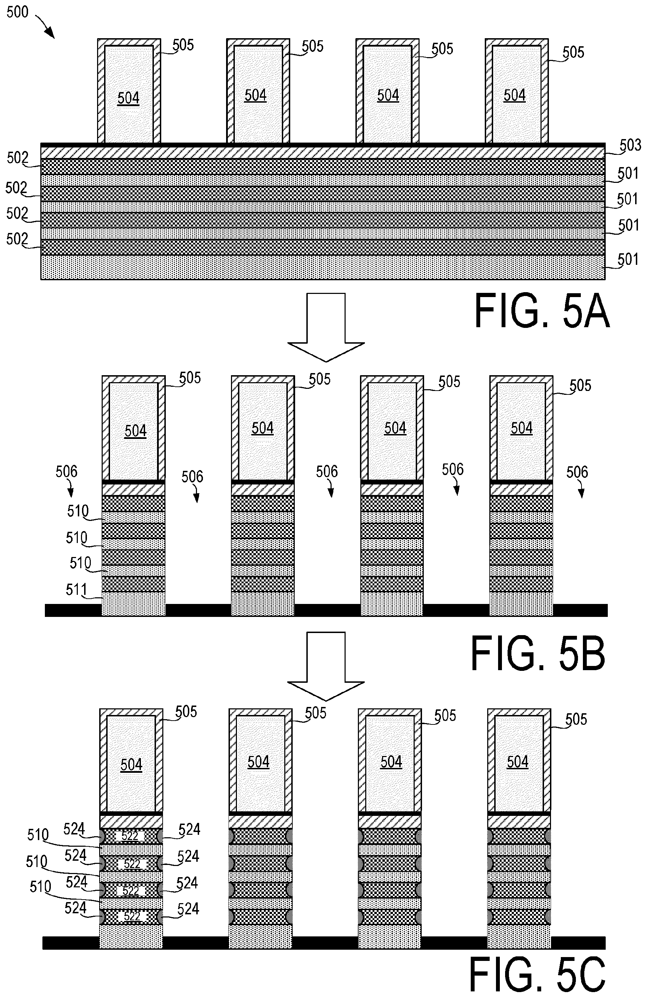

FIGS. 5A-5K illustrate another example process 500 of forming GAA FETs in accordance with some embodiments. The example process 500 may include fewer, additional, or other operations than those shown. Moreover, the operations of the process 500 can be performed in another order than shown. Furthermore, some of the operations shown or described as being separate may be performed simultaneously, while some of the operations shown or described as being performed at the same time may be performed at different times. Although a certain number of nanoribbons are shown in the transistors, any number of nanoribbons or other types of transistor channels can be formed using the process 500.

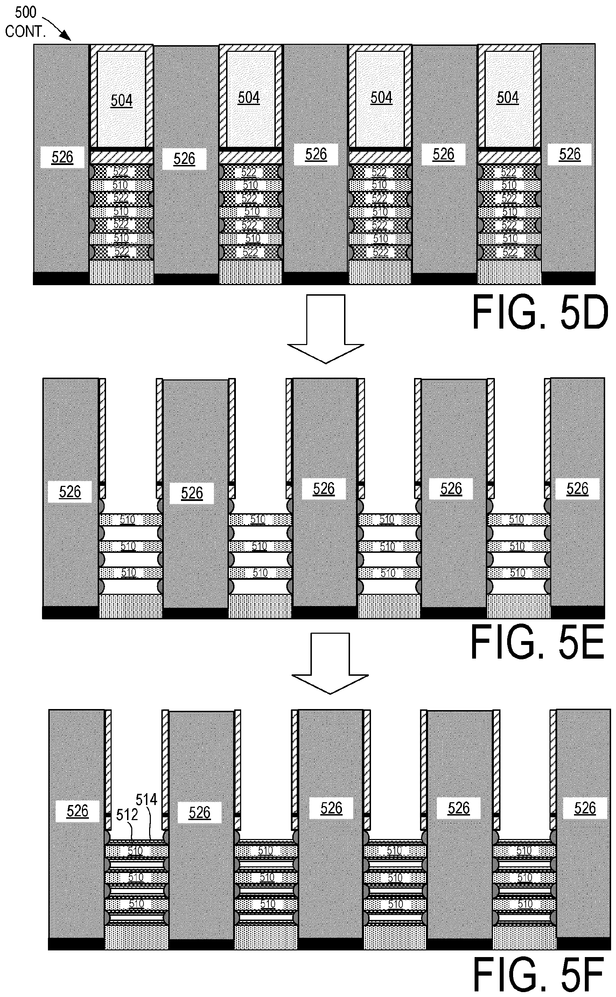

The process 500 begins as shown in FIG. 5A, with the formation of dummy gate regions 504 on a stack of materials, which includes layers 501, 502, 503. The layers 501 may include crystalline (e.g., semiconductor) materials and the layers 502 may include sacrificial materials. In some embodiments, the sacrificial material layers 502 may include silicon germanium (SiGe) and the crystalline material layers 501 may include pure (or predominantly) silicon (e.g., without germanium present). The layer 503 may include a dielectric. In addition, a dielectric layer 505 is formed on each of the dummy gate regions 504 as shown. The stack is then selectively etched in regions 506 as shown in FIG. 5B to form stacks of nanoribbons 510 (from the remaining portions of the layers 501) over respective sub-fins 511. Spacer dimples 524 are then formed on the sides of the sacrificial material layers 522 (remaining from layers 502) as shown in FIG. 5C. The spacer dimples 524 may include any suitable dielectric material. Then, dummy source/drain regions 526 are formed on the sides of the stacks of nanoribbons 510 as shown in FIG. 5D (in the etched regions 506). The nanoribbons 510 may then be released as shown in FIG. 5E, which includes removing (e.g., selective etching) the dummy gate regions 504 and removing (e.g., selectively etching) the sacrificial material layers 522 adjacent to the nanoribbons 510.

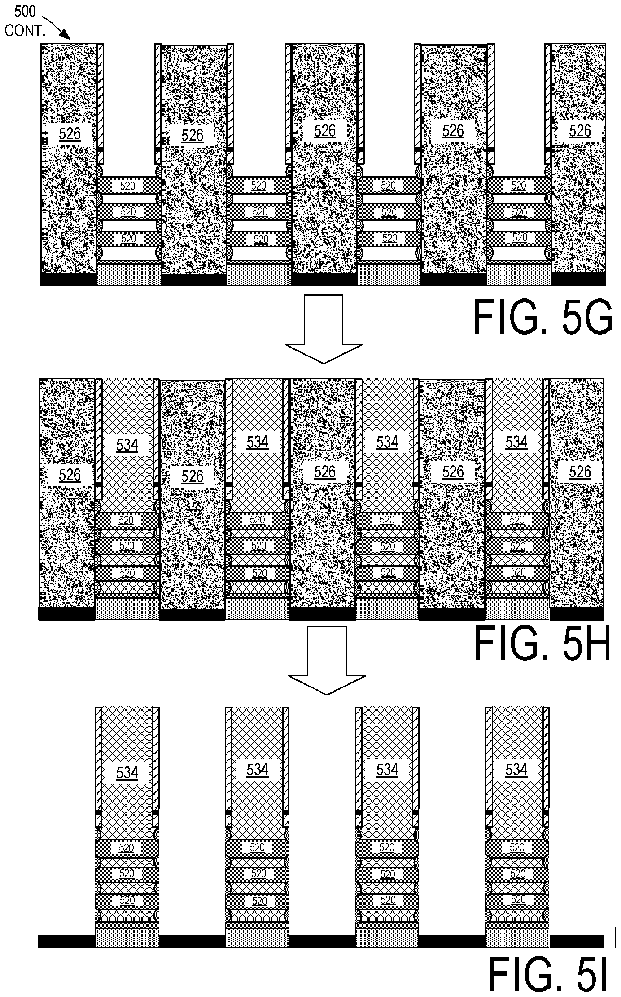

One or more aspects of the process described above with respect to FIGS. 2A-2F can then be performed on the released nanoribbons. For instance, as shown in FIG. 5F, a layer 512 of additive material is formed over each of the released nanoribbons 510 and then a layer 514 of capping material is formed over the layers 512. The layers 512 and 514 may be formed in the same manner as layers 512 and 514, respectively. Similarly, the layers 512, 514 may include the same or similar materials as layers 512, 514. The additive material in the layers 512 can then be diffused into the nanoribbons 510, yielding enhanced nanoribbons 520 as described above. The capping layer 514 can then be removed, with the resulting structure being shown in FIG. 5G. In certain embodiments, the enhanced nanoribbons 520 may include uniform and homogenous silicon germanium, with a germanium concentration between approximately 20% and 70%.

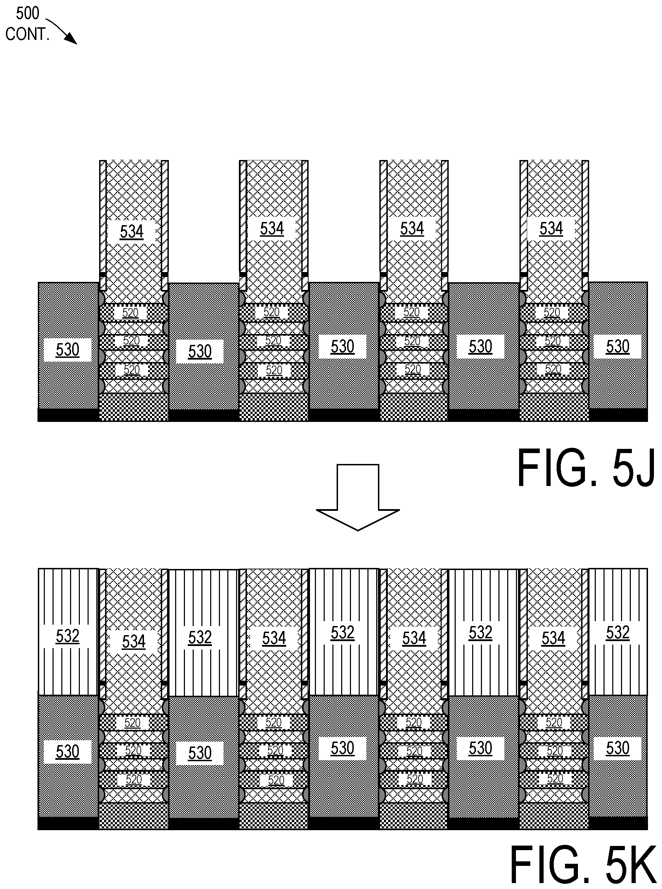

Gate regions 534 may then be formed above and between the enhanced nanoribbons 520 as shown in FIG. 5H, and the dummy source/drain regions 526 can then be removed as shown in FIG. 5I. Source/drain regions 530 can be epitaxially formed on sides of the stacks of enhanced nanoribbons 520 as shown in FIG. 5J (e.g., epitaxially grown from the channel nanoribbons 520), and then gate spacer dielectric 532 can be formed on each of the source/drain regions as shown in FIG. 5K. The source/drain regions 530 may be doped with one or more dopants, e.g., p-type dopants such as boron, aluminum, or gallium.

In the above examples, the source/drain regions 430, 530 may include (or contact) interface layers between the regions 430, 530 and the enhanced nanoribbon channels of the transistors. The interface layers may contact end of the enhanced nanoribbons 220 and may be thin layers, e.g., only as thick as necessary to serve as a growth template (e.g., nucleation layer) for the growth of the source/drain regions. The interface layers may have a lower dopant concentration than the source/drain regions (including a dopant concentration of zero in some embodiments). The interface layers may have a concentration of the additive element (e.g., germanium) that is less than the concentration of the additive element in the enhanced nanoribbons.

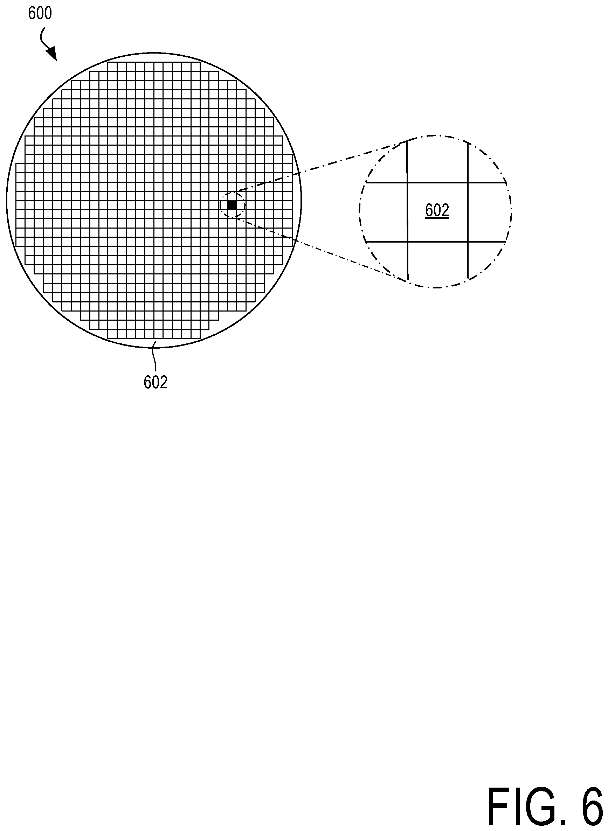

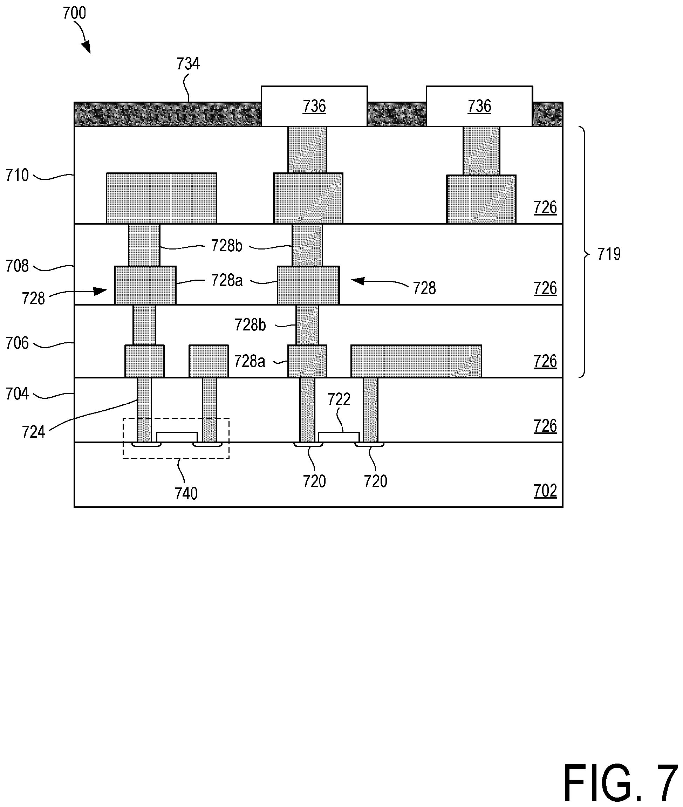

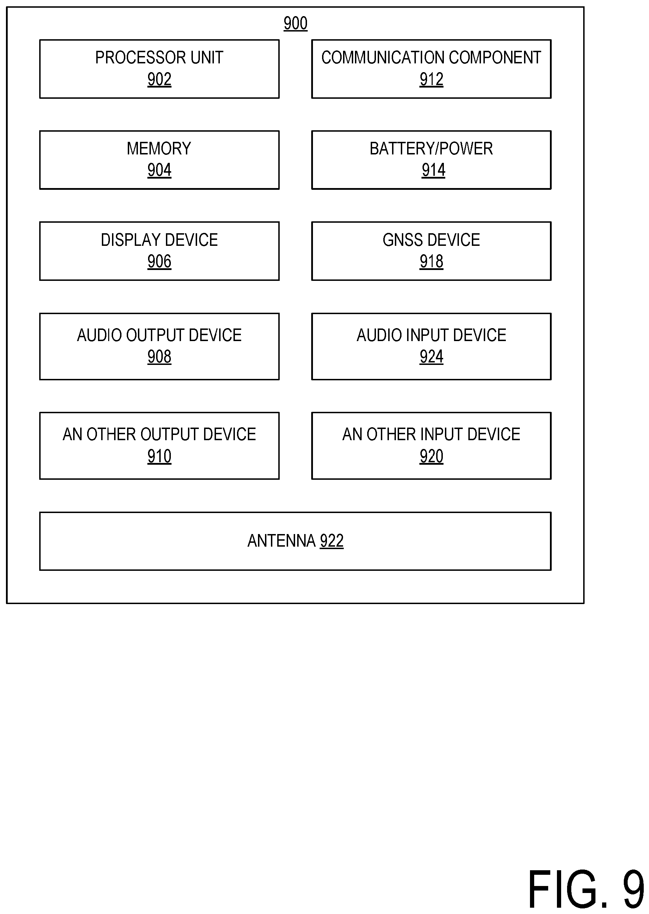

FIG. 6 is a top view of a wafer 600 and dies 602 that may incorporate any of the embodiments disclosed herein. The wafer 600 may be composed of semiconductor material and may include one or more dies 602 having integrated circuit structures formed on a surface of the wafer 600. The individual dies 602 may be a repeating unit of an integrated circuit product that includes any suitable integrated circuit. After the fabrication of the semiconductor product is complete, the wafer 600 may undergo a singulation process in which the dies 602 are separated from one another to provide discrete "chips" of the integrated circuit product. The die 602 may include one or more transistors (e.g., some of the transistors 740 of FIG. 7, discussed below), supporting circuitry to route electrical signals to the transistors, passive components (e.g., signal traces, resistors, capacitors, or inductors), and/or any other integrated circuit components. In some embodiments, the wafer 600 or the die 602 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 602. For example, a memory array formed by multiple memory devices may be formed on a same die 602 as a processor unit (e.g., the processor unit 902 of FIG. 9) or other logic that is configured to store information in the memory devices or execute instructions stored in the memory array.

FIG. 7 is a cross-sectional side view of an integrated circuit device 700 that may be included in embodiments herein. One or more of the integrated circuit devices 700 may be included in one or more dies 602 (FIG. 6). The integrated circuit device 700 may be formed on a die substrate 702 (e.g., the wafer 600 of FIG. 6) and may be included in a die (e.g., the die 602 of FIG. 6). The die substrate 702 may be a semiconductor substrate composed of semiconductor material systems including, for example, n-type or p-type materials systems (or a combination of both). The die substrate 702 may include, for example, a crystalline substrate formed using a bulk silicon or a silicon-on-insulator (SOI) substructure. In some embodiments, the die substrate 702 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 702. Although a few examples of materials from which the die substrate 702 may be formed are described here, any material that may serve as a foundation for an integrated circuit device 700 may be used. The die substrate 702 may be part of a singulated die (e.g., the dies 602 of FIG. 6) or a wafer (e.g., the wafer 600 of FIG. 6).

The integrated circuit device 700 may include one or more device layers 704 disposed on the die substrate 702. The device layer 704 may include features of one or more transistors 740 (e.g., FeFETs as described herein) formed on the die substrate 702. The transistors 740 may include, for example, one or more source and/or drain (S/D) regions 720, a gate 722 to control current flow between the S/D regions 720, and one or more S/D contacts 724 to route electrical signals to/from the S/D regions 720. The transistors 740 may include additional features not depicted for the sake of clarity, such as device isolation regions, gate contacts, and the like. The transistors 740 are not limited to the type and configuration depicted in FIG. 7 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

A transistor 740 may include a gate 722 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 740 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 740 along the source-channel-drain direction, the gate electrode may consist of a U-shaped structure that includes a bottom portion substantially parallel to the surface of the die substrate 702 and two sidewall portions that are substantially perpendicular to the top surface of the die substrate 702. In other embodiments, at least one of the metal layers that form the gate electrode may simply be a planar layer that is substantially parallel to the top surface of the die substrate 702 and does not include sidewall portions substantially perpendicular to the top surface of the die substrate 702. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 720 may be formed within the die substrate 702 adjacent to the gate 722 of individual transistors 740. The S/D regions 720 may be formed using an implantation/diffusion process or an etching/deposition process, for example. In the former process, dopants such as boron, aluminum, antimony, phosphorous, or arsenic may be ion-implanted into the die substrate 702 to form the S/D regions 720. An annealing process that activates the dopants and causes them to diffuse farther into the die substrate 702 may follow the ion-implantation process. In the latter process, the die substrate 702 may first be etched to form recesses at the locations of the S/D regions 720. An epitaxial deposition process may then be carried out to fill the recesses with material that is used to fabricate the S/D regions 720. In some implementations, the S/D regions 720 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 720 may be formed using one or more alternate semiconductor materials such as germanium or a group III-V material or alloy. In further embodiments, one or more layers of metal and/or metal alloys may be used to form the S/D regions 720.

Electrical signals, such as power and/or input/output (I/O) signals, may be routed to and/or from the devices (e.g., transistors 740) of the device layer 704 through one or more interconnect layers disposed on the device layer 704 (illustrated in FIG. 7 as interconnect layers 706-710). For example, electrically conductive features of the device layer 704 (e.g., the gate 722 and the S/D contacts 724) may be electrically coupled with the interconnect structures 728 of the interconnect layers 706-710. The one or more interconnect layers 706-710 may form a metallization stack (also referred to as an "ILD stack") 719 of the integrated circuit device 700.

The interconnect structures 728 may be arranged within the interconnect layers 706-710 to route electrical signals according to a wide variety of designs; in particular, the arrangement is not limited to the particular configuration of interconnect structures 728 depicted in FIG. 7. Although a particular number of interconnect layers 706-710 is depicted in FIG. 7, embodiments of the present disclosure include integrated circuit devices having more or fewer interconnect layers than depicted.

In some embodiments, the interconnect structures 728 may include lines 728a and/or vias 728b filled with an electrically conductive material such as a metal. The lines 728a may be arranged to route electrical signals in a direction of a plane that is substantially parallel with a surface of the die substrate 702 upon which the device layer 704 is formed. For example, the lines 728a may route electrical signals in a direction in and out of the page and/or in a direction across the page from the perspective of FIG. 7. The vias 728b may be arranged to route electrical signals in a direction of a plane that is substantially perpendicular to the surface of the die substrate 702 upon which the device layer 704 is formed. In some embodiments, the vias 728b may electrically couple lines 728a of different interconnect layers 706-710 together.

The interconnect layers 706-710 may include a dielectric material 726 disposed between the interconnect structures 728, as shown in FIG. 7. In some embodiments, dielectric material 726 disposed between the interconnect structures 728 in different ones of the interconnect layers 706-710 may have different compositions; in other embodiments, the composition of the dielectric material 726 between different interconnect layers 706-710 may be the same. The device layer 704 may include a dielectric material 726 disposed between the transistors 740 and a bottom layer of the metallization stack as well. The dielectric material 726 included in the device layer 704 may have a different composition than the dielectric material 726 included in the interconnect layers 706-710; in other embodiments, the composition of the dielectric material 726 in the device layer 704 may be the same as a dielectric material 726 included in any one of the interconnect layers 706-710.

A first interconnect layer 706 (referred to as Metal 1 or "M1") may be formed directly on the device layer 704. In some embodiments, the first interconnect layer 706 may include lines 728a and/or vias 728b, as shown. The lines 728a of the first interconnect layer 706 may be coupled with contacts (e.g., the S/D contacts 724) of the device layer 704. The vias 728b of the first interconnect layer 706 may be coupled with the lines 728a of a second interconnect layer 708.

The second interconnect layer 708 (referred to as Metal 2 or "M2") may be formed directly on the first interconnect layer 706. In some embodiments, the second interconnect layer 708 may include via 728b to couple the lines 728a of the second interconnect layer 708 with the lines 728a of a third interconnect layer 710. Although the lines 728a and the vias 728b are structurally delineated with a line within individual interconnect layers for the sake of clarity, the lines 728a and the vias 728b may be structurally and/or materially contiguous (e.g., simultaneously filled during a dual-damascene process) in some embodiments.

The third interconnect layer 710 (referred to as Metal 3 or "M3") (and additional interconnect layers, as desired) may be formed in succession on the second interconnect layer 708 according to similar techniques and configurations described in connection with the second interconnect layer 708 or the first interconnect layer 706. In some embodiments, the interconnect layers that are "higher up" in the metallization stack 719 in the integrated circuit device 700 (i.e., farther away from the device layer 704) may be thicker that the interconnect layers that are lower in the metallization stack 719, with lines 728a and vias 728b in the higher interconnect layers being thicker than those in the lower interconnect layers.

The integrated circuit device 700 may include a solder resist material 734 (e.g., polyimide or similar material) and one or more conductive contacts 736 formed on the interconnect layers 706-710. In FIG. 7, the conductive contacts 736 are illustrated as taking the form of bond pads. The conductive contacts 736 may be electrically coupled with the interconnect structures 728 and configured to route the electrical signals of the transistor(s) 740 to external devices. For example, solder bonds may be formed on the one or more conductive contacts 736 to mechanically and/or electrically couple an integrated circuit die including the integrated circuit device 700 with another component (e.g., a printed circuit board). The integrated circuit device 700 may include additional or alternate structures to route the electrical signals from the interconnect layers 706-710; for example, the conductive contacts 736 may include other analogous features (e.g., posts) that route the electrical signals to external components.

In some embodiments in which the integrated circuit device 700 is a double-sided die, the integrated circuit device 700 may include another metallization stack (not shown) on the opposite side of the device layer(s) 704. This metallization stack may include multiple interconnect layers as discussed above with reference to the interconnect layers 706-710, to provide conductive pathways (e.g., including conductive lines and vias) between the device layer(s) 704 and additional conductive contacts (not shown) on the opposite side of the integrated circuit device 700 from the conductive contacts 736.

In other embodiments in which the integrated circuit device 700 is a double-sided die, the integrated circuit device 700 may include one or more through silicon vias (TSVs) through the die substrate 702; these TSVs may make contact with the device layer(s) 704, and may provide conductive pathways between the device layer(s) 704 and additional conductive contacts (not shown) on the opposite side of the integrated circuit device 700 from the conductive contacts 736. In some embodiments, TSVs extending through the substrate can be used for routing power and ground signals from conductive contacts on the opposite side of the integrated circuit device 700 from the conductive contacts 736 to the transistors 740 and any other components integrated into the die, and the metallization stack 719 can be used to route I/O signals from the conductive contacts 736 to transistors 740 and any other components integrated into the die.

Multiple integrated circuit devices 700 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

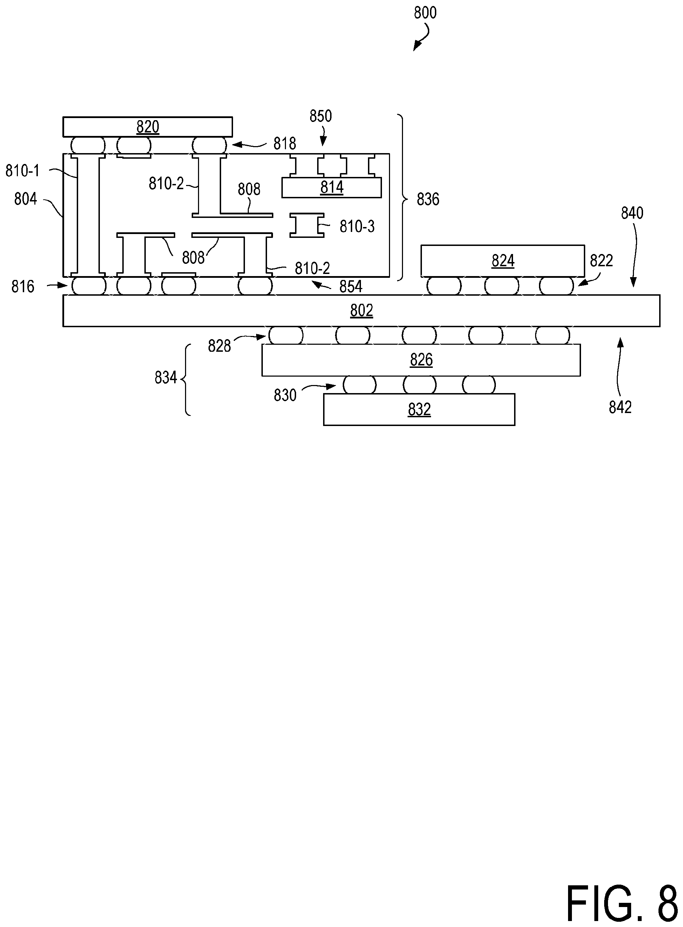

FIG. 8 is a cross-sectional side view of an integrated circuit device assembly 800 that may include any of the embodiments disclosed herein. The integrated circuit device assembly 800 includes a number of components disposed on a circuit board 802 (which may be a motherboard, system board, mainboard, etc.). The integrated circuit device assembly 800 includes components disposed on a first face 840 of the circuit board 802 and an opposing second face 842 of the circuit board 802; generally, components may be disposed on one or both faces 840 and 842.

In some embodiments, the circuit board 802 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 802. In other embodiments, the circuit board 802 may be a non-PCB substrate. The integrated circuit device assembly 800 illustrated in FIG. 8 includes a package-on-interposer structure 836 coupled to the first face 840 of the circuit board 802 by coupling components 816. The coupling components 816 may electrically and mechanically couple the package-on-interposer structure 836 to the circuit board 802, and may include solder balls (as shown in FIG. 8), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 836 may include an integrated circuit component 820 coupled to an interposer 804 by coupling components 818. The coupling components 818 may take any suitable form for the application, such as the forms discussed above with reference to the coupling components 816. Although a single integrated circuit component 820 is shown in FIG. 8, multiple integrated circuit components may be coupled to the interposer 804; indeed, additional interposers may be coupled to the interposer 804. The interposer 804 may provide an intervening substrate used to bridge the circuit board 802 and the integrated circuit component 820.

The integrated circuit component 820 may be a packaged or unpacked integrated circuit product that includes one or more integrated circuit dies (e.g., the die 602 of FIG. 6, the integrated circuit device 700 of FIG. 7) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 820, a single monolithic integrated circuit die comprises solder bumps attached to contacts on the die. The solder bumps allow the die to be directly attached to the interposer 804. The integrated circuit component 820 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 820 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 820 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 820 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 804 may spread connections to a wider pitch or reroute a connection to a different connection. For example, the interposer 804 may couple the integrated circuit component 820 to a set of ball grid array (BGA) conductive contacts of the coupling components 816 for coupling to the circuit board 802. In the embodiment illustrated in FIG. 8, the integrated circuit component 820 and the circuit board 802 are attached to opposing sides of the interposer 804; in other embodiments, the integrated circuit component 820 and the circuit board 802 may be attached to a same side of the interposer 804. In some embodiments, three or more components may be interconnected by way of the interposer 804.

In some embodiments, the interposer 804 may be formed as a PCB, including multiple metal layers separated from one another by layers of dielectric material and interconnected by electrically conductive vias. In some embodiments, the interposer 804 may be formed of an epoxy resin, a fiberglass-reinforced epoxy resin, an epoxy resin with inorganic fillers, a ceramic material, or a polymer material such as polyimide. In some embodiments, the interposer 804 may be formed of alternate rigid or flexible materials that may include the same materials described above for use in a semiconductor substrate, such as silicon, germanium, and other group III-V and group IV materials. The interposer 804 may include metal interconnects 808 and vias, including but not limited to through hole vias 810-1 (that extend from a first face 850 of the interposer 804 to a second face 854 of the interposer 804), blind vias 810-2 (that extend from the first or second faces 850 or 854 of the interposer 804 to an internal metal layer), and buried vias 810-3 (that connect internal metal layers).

In some embodiments, the interposer 804 can comprise a silicon interposer. Through silicon vias (TSV) extending through the silicon interposer can connect connections on a first face of a silicon interposer to an opposing second face of the silicon interposer. In some embodiments, an interposer 804 comprising a silicon interposer can further comprise one or more routing layers to route connections on a first face of the interposer 804 to an opposing second face of the interposer 804.

The interposer 804 may further include embedded devices 814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 804. The package-on-interposer structure 836 may take the form of any of the package-on-interposer structures known in the art. In embodiments where the interposer is a non-printed circuit board

The integrated circuit device assembly 800 may include an integrated circuit component 824 coupled to the first face 840 of the circuit board 802 by coupling components 822. The coupling components 822 may take the form of any of the embodiments discussed above with reference to the coupling components 816, and the integrated circuit component 824 may take the form of any of the embodiments discussed above with reference to the integrated circuit component 820.

The integrated circuit device assembly 800 illustrated in FIG. 8 includes a package-on-package structure 834 coupled to the second face 842 of the circuit board 802 by coupling components 828. The package-on-package structure 834 may include an integrated circuit component 826 and an integrated circuit component 832 coupled together by coupling components 830 such that the integrated circuit component 826 is disposed between the circuit board 802 and the integrated circuit component 832. The coupling components 828 and 830 may take the form of any of the embodiments of the coupling components 816 discussed above, and the integrated circuit components 826 and 832 may take the form of any of the embodiments of the integrated circuit component 820 discussed above. The package-on-package structure 834 may be configured in accordance with any of the package-on-package structures known in the art.

FIG. 9 is a block diagram of an example electrical device 900 that may include one or more of the embodiments disclosed herein. For example, any suitable ones of the components of the electrical device 900 may include one or more of the integrated circuit device assemblies 800, integrated circuit components 820, integrated circuit devices 700, or integrated circuit dies 602 disclosed herein. A number of components are illustrated in FIG. 9 as included in the electrical device 900, but any one or more of these components may be omitted or duplicated, as suitable for the application. In some embodiments, some or all of the components included in the electrical device 900 may be attached to one or more motherboards mainboards, or system boards. In some embodiments, one or more of these components are fabricated onto a single system-on-a-chip (SoC) die.

Additionally, in various embodiments, the electrical device 900 may not include one or more of the components illustrated in FIG. 9, but the electrical device 900 may include interface circuitry for coupling to the one or more components. For example, the electrical device 900 may not include a display device 906, but may include display device interface circuitry (e.g., a connector and driver circuitry) to which a display device 906 may be coupled. In another set of examples, the electrical device 900 may not include an audio input device 924 or an audio output device 908, but may include audio input or output device interface circuitry (e.g., connectors and supporting circuitry) to which an audio input device 924 or audio output device 908 may be coupled.

The electrical device 900 may include one or more processor units 902 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 900 may include a memory 904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 904 may include memory that is located on the same integrated circuit die as the processor unit 902. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 900 can comprise one or more processor units 902 that are heterogeneous or asymmetric to another processor unit 902 in the electrical device 900. There can be a variety of differences between the processing units 902 in a system in terms of a spectrum of metrics of merit including architectural, microarchitectural, thermal, power consumption characteristics, and the like. These differences can effectively manifest themselves as asymmetry and heterogeneity among the processor units 902 in the electrical device 900.

In some embodiments, the electrical device 900 may include a communication component 912 (e.g., one or more communication components). For example, the communication component 912 can manage wireless communications for the transfer of data to and from the electrical device 900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 912 may operate in accordance with Code Division Multiple Access

(CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 912 may operate in accordance with other wireless protocols in other embodiments. The electrical device 900 may include an antenna 922 to facilitate wireless communications and/or to receive other wireless communications (such as AM or FM radio transmissions).

In some embodiments, the communication component 912 may manage wired communications, such as electrical, optical, or any other suitable communication protocols (e.g., IEEE 802.3 Ethernet standards). As noted above, the communication component 912 may include multiple communication components. For instance, a first communication component 912 may be dedicated to shorter-range wireless communications such as Wi-Fi or Bluetooth, and a second communication component 912 may be dedicated to longer-range wireless communications such as global positioning system (GPS), EDGE, GPRS, CDMA, WiMAX, LTE, EV-DO, or others. In some embodiments, a first communication component 912 may be dedicated to wireless communications, and a second communication component 912 may be dedicated to wired communications.

The electrical device 900 may include battery/power supply circuitry 914. The battery/power supply circuitry 914 may include one or more energy storage devices (e.g., batteries or capacitors) and/or circuitry for coupling components of the electrical device 900 to an energy source separate from the electrical device 900 (e.g., AC line power).

The electrical device 900 may include a display device 906 (or corresponding interface circuitry, as discussed above). The display device 906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 900 may include an audio output device 908 (or corresponding interface circuitry, as discussed above). The audio output device 908 may include any embedded or wired or wirelessly connected external device that generates an audible indicator, such speakers, headsets, or earbuds.

The electrical device 900 may include an audio input device 924 (or corresponding interface circuitry, as discussed above). The audio input device 924 may include any embedded or wired or wirelessly connected device that generates a signal representative of a sound, such as microphones, microphone arrays, or digital instruments (e.g., instruments having a musical instrument digital interface (MIDI) output). The electrical device 900 may include a Global Navigation Satellite System (GNSS) device 918 (or corresponding interface circuitry, as discussed above), such as a Global Positioning System (GPS) device. The GNSS device 918 may be in communication with a satellite-based system and may determine a geolocation of the electrical device 900 based on information received from one or more GNSS satellites, as known in the art.

The electrical device 900 may include another output device 910 (or corresponding interface circuitry, as discussed above). Examples of the other output device 910 may include an audio codec, a video codec, a printer, a wired or wireless transmitter for providing information to other devices, or an additional storage device.

The electrical device 900 may include another input device 920 (or corresponding interface circuitry, as discussed above). Examples of the other input device 920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 900 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 900 may be any other electronic device that processes data. In some embodiments, the electrical device 900 may comprise multiple discrete physical components. Given the range of devices that the electrical device 900 can be manifested as in various embodiments, in some embodiments, the electrical device 900 can be referred to as a computing device or a computing system.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

Further, concepts described herein are illustrated by way of example and not by way of limitation in the accompanying figures. It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons. Where considered appropriate, reference labels may have been repeated between certain Figures to indicate corresponding or analogous elements.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C). For the purposes of the present disclosure, the phrase "A and at least one of B and C" means (A and B), (A and C), or (A and B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact. The phrase "communicatively coupled" may refer to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate, and an integrated circuit component attached to a printed circuit board that send signals to or receives signals from other integrated circuit components or electronic devices attached to the printed circuit board.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

In various embodiments, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

In various embodiments, the term "adjacent" refers to layers or components that are in physical contact with each other. That is, there is no layer or component between the stated adjacent layers or components. For example, a layer X that is adjacent to a layer Y refers to a layer that is in physical contact with layer Y.

In various embodiments, the term "region" may refer to a volume of an apparatus, device, or other object. Thus, a conductive region may refer to a volume of conducive material, and a dielectric region may refer to a volume of dielectric material. Further, as used herein, the term "surrounds" may refer to a first material (or region of a material) encompassing all sides of another, second material in at least one cross-sectional dimension, and may include one or more intermediate materials between the first and second materials. The term "around" may be used similarly to the term "surrounds", i.e., a first material may be formed around a second material when the first material encompasses all sides of a second material in at least one cross-sectional dimension, and there may be one or more intermediate material layers between the first and second materials.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is a device comprising: a gate-all-around (GAA) transistor comprising: a plurality of channel regions, the channel regions comprising a first element and a second element; a gate region around each of the channel regions; and source/drain regions on opposite sides of the channel regions, the source/drain regions comprising one or more dopant elements; wherein the dopant elements are not present in the channel regions.

Example 2 includes the device of Example 1, wherein each channel region has a first thickness at a midpoint between the source/drain regions and a second thickness at an end adjacent to the source/drain regions, the first thickness greater than the second thickness.

Example 3 includes the device of Example 1 or 2, wherein each channel region comprises a crystal lattice of the first element with the second element diffused in the crystal lattice.

Example 4 includes the device of any one of Examples 1-3, wherein a concentration of the second element in the channel regions is between 20% and 70%.

Example 5 includes the device of Example 4, wherein the concentration of the second element is homogeneous throughout the channel regions.

Example 6 includes the device of any one of Examples 1-5, wherein the first element is silicon and the second element is germanium.

Example 7 includes the device of any one of Examples 1-6, wherein the dopant elements comprise boron.

Example 8 is a processor comprising the device of any one of Examples 1-7.

Example 9 is a system comprising the processor of Example 9 and one or more memory devices.

Example 10 is a method comprising: forming a plurality of nanoribbons of crystalline material, wherein forming the nanoribbons comprises: forming a first layer on the nanoribbons, the first layer comprising an additive element not in the crystalline material; forming a second layer one the first layer; and heating the nanoribbons, the first layer, and the second layer to diffuse the additive element into the crystalline material; and after the heating to diffuse the additive element, forming source/drain regions on opposite sides of the nanoribbons.

Example 11 includes the method of Example 10, wherein the method comprises: forming stacks comprising alternating crystalline material layers and sacrificial material layers; removing the sacrificial material layers from the stacks before forming the first layer and forming the second layer; removing the second layer after heating the nanoribbons, the first layer, and the second layer; forming a dielectric between the crystalline material layers before forming the source/drain regions; removing the dielectric after forming the source/drain regions; and forming a gate region around the crystalline material layers.

Example 12 includes the method of Example 10, wherein the method comprises: forming stacks comprising alternating crystalline material layers and sacrificial material layers; forming dielectric on opposite sides of the stacks; removing the sacrificial material layers before forming the first layer and the second layer; removing the second layer after heating the nanoribbons, the first layer, and the second layer; forming a gate region around the crystalline material layers; and removing the dielectric before forming the source/drain regions.

Example 13 includes the method of any one of Examples 10-12, wherein the first source/drain region and the second source/drain region are epitaxially grown from the nanoribbons.

Example 14 includes the method of any one of Examples 10-13, wherein the additive element is not present in the crystalline material layer before heating.

Example 15 includes the method of any one of Examples 10-14, wherein the crystalline material layers comprise silicon and the additive element is germanium.

Example 16 includes the method of any one of Examples 10-15, wherein the second layer comprises silicon and nitrogen.

Example 17 is a method comprising: forming a plurality of crystalline nanoribbons; forming an additive material layer around each of the nanoribbons, the additive material layer comprising an additive element not in the crystalline nanoribbons; forming a capping layer around each of the additive material layers; and diffusing the additive element into the nanoribbons by heating; removing the capping layer; forming a first source/drain region on a first side of the nanoribbons comprising the additive material; and forming a second source/drain region on a second side of the nanoribbons opposite the first side.

Example 18 includes the method of Example 17, wherein: forming stacks comprising alternating crystalline material layers and sacrificial material layers; removing the sacrificial material layers from the stacks to form the crystalline nanoribbons; forming a dielectric between the crystalline nanoribbons after the diffusion and before forming the source/drain regions; and removing the dielectric after forming the source/drain regions; and forming a gate region around the nanoribbons.

Example 19 includes the method of Example 17, wherein: forming stacks comprising alternating crystalline material layers and sacrificial material layers; forming dielectric on opposite sides of the stacks; removing the sacrificial material layers to form the crystalline nanoribbons; forming a gate region around the nanoribbons after the diffusion; and removing the dielectric before forming the source/drain regions.

Example 20 includes the method of any one of Examples 17-19, wherein the first source/drain region and the second source/drain region are epitaxially grown from the nanoribbons.

Example 21 includes the method of any one of Examples 17-20, wherein the additive element is not present in the crystalline nanoribbons before the diffusion by heating.

Example 22 includes the method of any one of Examples 17-21, wherein the additive material layer comprises silicon and germanium and the nanoribbons each comprise silicon and germanium after the diffusion by heating.

Example 23 includes the method of any one of Examples 17-22, wherein the capping layer comprises silicon and nitrogen.

## Claims

1. A device comprising:
a gate-all-around (GAA) transistor comprising:
a plurality of channel regions, the channel regions comprising a first element and a second element;
a gate region around each of the channel regions; and
source/drain regions on opposite sides of the channel regions, the source/drain regions comprising one or more dopant elements;
wherein the dopant elements are not present in the channel regions.

2. The device of claim 1, wherein each channel region has a first thickness at a midpoint between the source/drain regions and a second thickness at an end adjacent to the source/drain regions, the first thickness greater than the second thickness.

3. The device of claim 1 or 2, wherein each channel region comprises a crystal lattice of the first element with the second element diffused in the crystal lattice.

4. The device of any one of claims 1-3, wherein a concentration of the second element in the channel regions is between 20% and 70%.

5. The device of claim 4, wherein the concentration of the second element is homogeneous throughout the channel regions.

6. The device of any one of claims 1-5, wherein the first element is silicon and the second element is germanium.

7. The device of any one of claims 1-6, wherein the dopant elements comprise boron.

8. A processor comprising the device of any one of claims 1-7.

9. A system comprising the processor of claim 8 and one or more memory devices.

10. A method comprising:
forming a plurality of nanoribbons of crystalline material, wherein forming the nanoribbons comprises:
forming a first layer on the nanoribbons, the first layer comprising an additive element not in the crystalline material;
forming a second layer one the first layer; and
heating the nanoribbons, the first layer, and the second layer to diffuse the additive element into the crystalline material; and
after the heating to diffuse the additive element, forming source/drain regions on opposite sides of the nanoribbons.

11. The method of claim 10, wherein the method comprises:
forming stacks comprising alternating crystalline material layers and sacrificial material layers;
removing the sacrificial material layers from the stacks before forming the first layer and forming the second layer;
removing the second layer after heating the nanoribbons, the first layer, and the second layer;
forming a dielectric between the crystalline material layers before forming the source/drain regions;
removing the dielectric after forming the source/drain regions; and
forming a gate region around the crystalline material layers.

12. The method of claim 10, wherein the method comprises:
forming stacks comprising alternating crystalline material layers and sacrificial material layers;
forming dielectric on opposite sides of the stacks;
removing the sacrificial material layers before forming the first layer and the second layer;
removing the second layer after heating the nanoribbons, the first layer, and the second layer;
forming a gate region around the crystalline material layers; and
removing the dielectric before forming the source/drain regions.

13. The method of any one of claims 10-12, wherein the first source/drain region and the second source/drain region are epitaxially grown from the nanoribbons.

14. The method of any one of claims 10-13, wherein the crystalline material layers comprise silicon and the additive element is germanium.

15. The method of any one of claims 10-14, wherein the second layer comprises silicon and nitrogen.
